# EUROPÄISCHE PATENTSCHRIFT

(11) **EP 0 499 670 B1**
(45) Veröffentlichungstag und Bekanntmachung des Hinweises auf die Patenterteilung: **11.10.1995**
(21) Anmeldenummer: 91102469.3
(22) Anmeldetag: 20.02.1991
(51) Int. Cl.: B60T 8/36

(54) **Ventilsteuergerät**
Valve control device
Dispositif de commande de valves

(43) Veröffentlichungstag der Anmeldung: 26.08.1992
(73) Patentinhaber: SIEMENS AKTIENGESELLSCHAFT, 80333 München (DE)
(72) Erfinder: Schöttl, Johannes, Dipl.-Ing. (FH), W-8407 Obertraubling (DE)

(56) Entgegenhaltungen:
- EP-A- 0 105 219
- EP-A- 0 373 551
- WO-A-89/10286
- DE-A- 3 012 650
- DE-A- 3 836 405
- DE-A- 3 906 548

## Beschreibung

Die Erfindung betrifft ein Gerät zum Steuern von Ventilen (Ventilsteuergerät) nach dem Oberbegriff von Anspruch 1. Ein solches Ventilsteuergerät ist z.B. ein elektronisches Steuergerät für ein Antiblockiersystem (ABS), bei dem die die Radbremsen betätigende Bremsflüssigkeit mit zwei Ventilen pro Rad gesteuert wird. Die Ventile werden je durch einen Elektromagneten betätigt und sie sind in der Regel in einem sogenannten Ventilblock zusammengefaßt.

In der WO-A- 89/10286 ist eine elektrohydraulische Druckregelvorrichtung beschrieben, die aus einem oder mehreren elektromagnetisch betätigten Hydraulikventilen besteht, die einen Ventilblock bilden. Dieser schließt ein Gehäuse ab, das einen Rahmen und einen auf dem Rahmen angeordneten Deckel aufweist. Das Gehäuse umschließt von dem Ventilblock abstehende Spulenteile, Kontaktelemente und ein Trägerelement für Leiterbahnen. Eine getrennte Vorfertigung eines alle elektrischen Komponenten enthaltenden Gerätes und eines nur die mechanischen Teile enthaltenden Ventilblocks ist hier weder vorgesehen noch möglich.

Die DE-A-3906548 beschreibt ein Drucksteuerventil mit einem Magnetventil, das innerhalb eines Gehäuses durch eine Vergußmasse in dem Gehäuse druckdicht und damit abgeschirmt gegen Umwelteinflüsse wie Feuchtigkeit und Verschmutzung gehalten wird. Gleichzeitig ist eine gute Wärmeableitung von der Spule des Magnetventils gegeben.

Bei einem bekannten ABS-System (US-PS 3 910 647) ist das elektrische Steuergerät in einem von den Ventilblöcken für die Vorder- und für die Hinterräder getrennten Gehäuse untergebracht. Aus Platzgründen ist es aber zweckmäßig, den Ventilblock und das Ventilsteuergerät baulich zusammenzufassen.

Beim Montieren eines solchen integrierten Gerätes müssen die in dem Steuerteil enthaltenen Elektromagnet-Spulen auf die zylinderartigen Gehäuse der einzelnen Ventile des Ventilblocks gemeinsam aufgeschoben werden. Dabei können Toleranzprobleme auftreten, wenn die Achsen sämtlicher Spulenkörper nicht exakt mit den Achsen sämtlicher Ventil-Einzelgehäuse übereinstimmen.

Der Erfindung liegt die Aufgabe zugrunde, ein Ventilsteuergerät zu schaffen, das in der Lage ist, Fertigungstoleranzen des Ventilblocks auszugleichen und somit eine leichte Montage ermöglicht.

Diese Aufgabe wird erfindungsgemäß durch ein Ventilsteuergerät mit den Merkmalen von Anspruch 1 gelöst.

Vorteilhafte Weiterbildungen der Erfindung ergeben sich aus den Unteransprüchen.

Das nachgiebige Einbetten der Elektromagnet-Spulen in den Gehäuserahmen hat den Vorteil, daß die elastische Masse in die die Spulen eingebettet sind, gleichzeitig die elektronischen Bestandteile des Ventilsteuergerätes gegen die Umgebung abdichtet.

Ein Ausführungsbeispiel wird im folgenden anhand der Zeichnung erläutert. Es zeigen:
- Figur 1: ein Ventilsteuergerät gemäß der Erfindung in einer auseinandergezogenen Perspektivdarstellung,
- Figur 2: ein Ausschnitt aus dem Ventilsteuergerät nach Figur 1, das die elektrische Verbindung zwischen einer Ventilspule und einem Schaltungsträger des Geräts verdeutlicht,
- Figur 3: einen bei der Verbindung nach Figur 2 verwendeten Lötkontakt in vergrößertem Maßstab,
- Figur 4: eine andere Ausführung des erfindungsgemäßen Ventilsteuergeräts in einem Längsschnitt und
- Figur 5: das Ventilsteuergerät nach Figur 4 in einer seitlichen Schnittansicht.

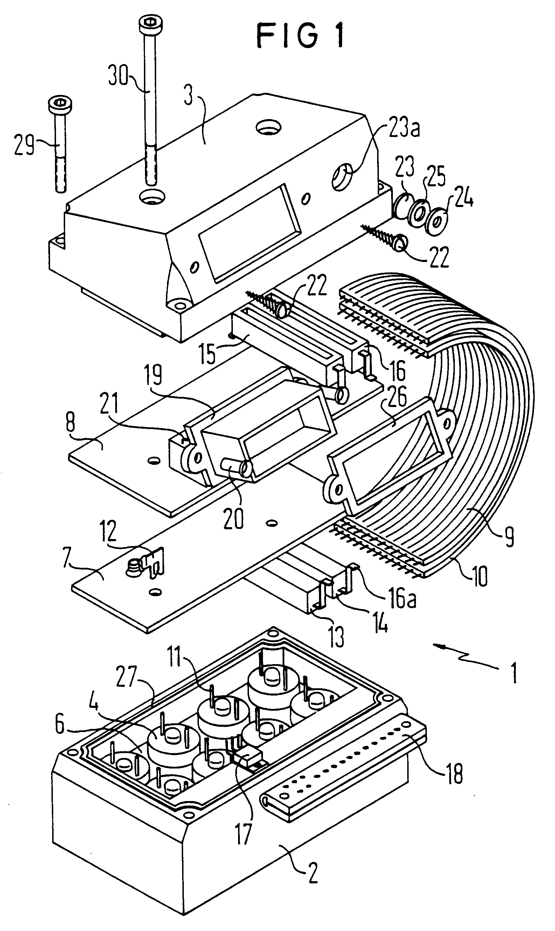

Ein Ventilsteuergerät 1 (Figur 1) weist ein Gehäuse auf, das im wesentlichen aus einem Gehäuse-Rahmen 2 und einem Deckel 3 besteht. Der Rahmen 2 ist z.B. aus Aluminium und der Deckel 3 aus Kunststoff hergestellt.

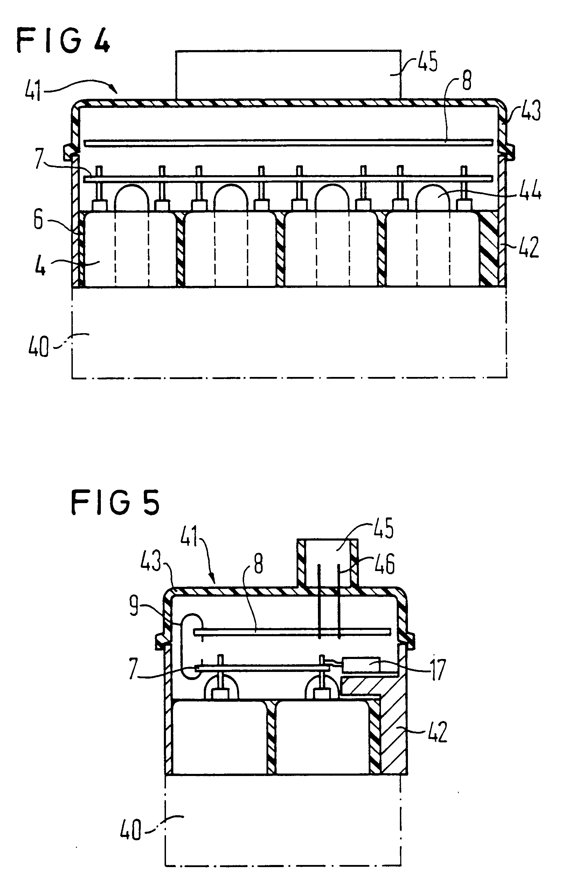

In dem Rahmen 2 sind Ventilspulen 4, d.h. die Spulenkörper und Wicklungen der einzelnen Elektromagnete für die Ventilbetätigung, nachgiebig eingebettet. Dies wird z.B. dadurch erreicht, daß die Ventilspulen 4 in ihrer Lage zu dem Rahmen 2 fixiert und die Zwischenräume mit einer Vergußmasse 6 aufgefüllt werden. Als Vergußmasse wird ein geeigneter Kunststoff, z.B. ein Polyurethan mit der nötigen Elastizität verwendet. Nach dem Aushärten der Vergußmasse 6 werden die Ventilspulen 4 in ihrer Lage gehalten, die Halterung ist aber so nachgiebig, daß Fertigungstoleranzen des Ventilblocks (vergleiche Figur 4 und 5) ohne weiteres ausgeglichen werden. Außerdem dichtet die Vergußmasse 6, die noch zu beschreibenden elektrischen Bestandteile gegen den Ventilblock und gegen die Umgebung ab, so daß sie gegen Umwelteinflüsse geschützt sind.

Im Inneren des aus Rahmen 2 und Deckel 3 bestehenden Gehäuses ist ein die elektrischen und elektronischen Schaltungsbestandteile aufnehmender Schaltungsträger angeordnet, der im dargestellten Ausführungsbeispiel aus einer ersten Leiterplatte 7 und einer zweiten Leiterplatte 8 besteht, die durch zwei Flachbandkabel 9, 10 nachgiebig miteinander verbunden sind. Die Leiterplatten 7 und 8 sind nur schematisch dargestellt, da die Schaltung selbst nicht Bestandteil der Erfindung ist. Geeignete ABS-Steuerschaltungen sind in vielfachen Ausführungen bekannt.

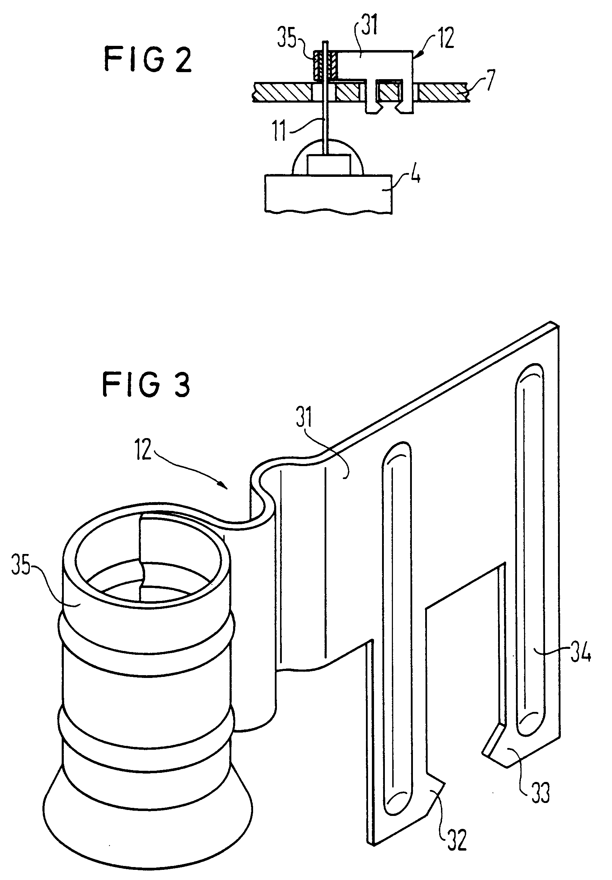

Die Anschlußdrähte 11 der Ventilspulen 4 werden mit den auf der Leiterplatte 2 angeordneten Leistungsbausteinen über Lötkontakte 12 verbunden, die ihrerseits mit - nicht dargestellten - Leiterbahnen der Leiterplatte 7 verbunden sind und die in Einzelheiten anhand der Figuren 3 und 4 zu erläutern sein werden.

Die Flachbandkabel 9 und 10 werden mit der Leiterplatte 7 verbunden, indem sie in Halter 13 bzw. 14 eingesteckt werden. Mit der Leiterplatte 8 werden sie über entsprechende Halter 15 bzw. 16 verbunden. Die Kalter 13 bis 16 sind auf den jeweiligen Leiterplatten 7, 8 durch Rasthaken 16a befestigt, die durch Bohrungen in der jeweiligen Leiterplatte hindurchgesteckt werden. Leistungsbauelemente 17, von denen in der Zeichnung nur eines dargestellt ist, sind zur besseren Wärmeabfuhr mit dem Gehäuse-Rahmen 2 breitflächig verklebt. Ihre nach oben umgeknickten Anschlußbeinchen werden durch Kontaktierungsbohrungen der Leiterplatte 7 hindurchgesteckt und verlötet. Um die Anschlußbeinchen bei der Montage sicher in die Kontaktierungsbohrungen einstecken zu können, ist an dem Rahmen 2 eine umklappbare Fädelhilfe 18 befestigt.

Ein Steckerteil in Form einer Messerleiste 19 ist an dem Deckel 3 mit Nieten 20 befestigt. Elektrisch ist es durch Leitungen 21 mit der Leiterplatte 8 verbunden. Ein in der Zeichnung nicht dargestelltes Stecker-Kupplungsteil wird auf die Messerleiste aufgeschoben mit zwei Schrauben 22 an den Deckel 3 befestigt. Zum Druckausgleich zwischen Gehäuseinneren und Umgebung dient eine Membranscheibe 23, die in eine Bohrung 23a mit Verbindung zum Gehäuseinneren eingesetzt ist. Sie wird dort durch einen eingepreßten Ring 24 mit dazwischenliegendem Dichtring 25 gehalten. Zwischen der Messerleiste 19 und dem auf sie aufzusteckenden Kupplungsteil sorgt eine Dichtung 26 für Dichtheit. Der Gehäuse-Rahmen 2 ist an seinem obenliegenden Rand mit einer durchgehenden Nut versehen, in die eine Dichtung 27 eingelegt ist, die für Dichtheit zwischen dem Rahmen 2 und dem Deckel 3 sorgt.

Der Deckel 3 wird mit dem Rahmen 2 durch vier Schrauben 29 verschraubt. Das gesamte Ventilgehäuse 1 wird mit zwei Schrauben 30 auf dem Ventilblock befestigt.

Die Lötkontakte 12 (Figuren 2 und 3) sind als Blechformteil ausgebildet. Sie weisen eine Befestigungsfahne 31 auf, die mit zwei nach unten hervorstehenden Rasthaken 32, 33 versehen ist, die durch je eine Sicke 34 verstärkt sind. An die Befestigungsfahne 31 schließt sich ein zylindrisch geformtes Lötauge 35 an. Die Befestigungsfahne 31 kann mit einem Lötstopplack überzogen sein.

Um den Lötkontakt 12 auf der Leiterplatte 7 zu befestigen, werden die Rasthaken 32, 33 durch entsprechende Bohrungen in der Leiterplatte 7 hindurchgesteckt und rasten dann an deren Unterseite ein. Die Leiterplatte 7 wird dann so in den Rahmen 2 eingeführt, daß die Anschlußdrähte 11 der Ventilspulen 4 durch jeweils ein Lötauge 35 hindurchragen. Dann wird die Leiterplatte 7 zusammen mit dem Rahmen 2 in ein Lötbad - z.B. ein Schwall-Lötbad - gebracht, in dem die Anschlußdrähte 11 mit dem jeweiligen Lötkontakt 12 verlötet werden. Es werden dabei auch die Rasthaken 32, 33 mit der Leiterplatte 7 verlötet. Die Schwallseite beim Löten ist die in der Zeichnung obenliegende Seite der Leiterplatte 7.

Ein anderes Ventilsteuergerät 41 (Figuren 4 und 5) ist in montiertem Zustand dargestellt, wobei ein zugehöriger Ventilblock 40 mit gestrichelten Linien angedeutet ist. Er weist acht Einzel-Ventilgehäuse oder Ventildome 44 auf, die hier in die Spulenkörper der Elektromagnet-Ventilspulen 4 bereits eingeschoben sind. Dabei ermöglicht die die Ventilspulen 4 in dem Rahmen 42 fixierende Vergußmasse 6 aufgrund ihrer Nachgiebigkeit ein einfaches Aufschieben des Ventilsteuergeräts 41 auf den Ventilblock 40.

Das Ventilsteuergerät 41 entspricht weitgehend dem Ventilsteuergerät 1. Der Deckel 43, der ein- oder zweiteilig ausgeführt sein kann, weist hier aber ein senkrecht nach oben ragendes Steckerteil 45 auf, das ebenfalls mit einer Messerleiste 46 versehen ist.

Die Leiterplatte 7 bildet auch hier die Leistungsplatine, sie ist mit Leistungsbausteinen 17 versehen, während die Leiterplatte 8 die Prozessorplatine bildet. Beide durch Flachbandkabel 9 verbundene Leiterplatten 7 und 8 können auch durch eine elastische Leiterplatte ersetzt werden.

## Patentansprüche

1. Gerät (1, 41), zum Steuern einer Druckflüssigkeit mittels Magnetventilen bestehend aus Ventil (44) und Ventilspule (4), zum Aufsetzen auf einen die Ventile (44) aufweisenden Ventilblock (40), mit einem Gehäuse (2, 3, 42, 43), das aus einem die Ventilspulen (4) umgebenden Gehäuserahmen (2, 42) und einem auf dem Gehäuserahmen (2, 42) aufsitzenden Deckel (3, 43) besteht und einen im Inneren des Gehäuses (2, 3, 42, 43) angeordneten Schaltungsträger (7, 8) aufweist
**dadurch gekennzeichnet**,
daß die Ventilspulen (4) in den Gehäuserahmen (2, 42) elastisch eingebettet und mit dem Schaltungsträger (7, 8) elektrisch verbunden sind.

2. Gerät nach Anspruch 1, dadurch gekennzeichnet, daß die Ventilspulen (4) in dem Rahmen (2, 42) in einer vorgegebenen Lage durch eine Vergußmasse (6) fixiert sind.

3. Gerät nach Anspruch 1, dadurch gekennzeichnet, daß der Schaltungsträger (7, 8) Lötkontakte (12) aufweist, die in ihn eingerastet sind und in die die Anschlüsse (11) der Ventilspulen (4) eingelötet sind.

## Claims

1. Device (1, 41) for controlling a pressure fluid by means of solenoid valves consisting of a valve (44) and a valve coil (4) to be fitted onto a valve block (40) which has the valves (44), having a housing (2, 3, 42, 43) which consists of a housing frame (2, 42) which surrounds the valve coils (4) and a cover (3, 43) which is seated on the housing frame (2, 42) and has a circuit carrier (7, 8) which is arranged in the interior of the housing (2, 3, 42, 43), characterized in that the valve coils (4) are elastically embedded in the housing frame (2, 42) and are electrically connected to the circuit carrier (7, 8).

2. Device according to Claim 1, characterized in that the valve coils (4) are fixed in the frame (2, 42) in a prescribed position by means of a sealing compound (6).

3. Device according to Claim 1, characterized in that the circuit carrier (7, 8) has solder contacts (4) which are latched into it and into which the terminals (11) of the valve coils (4) are soldered.

## Revendications

1. Appareil (1,41) pour commander un fluide sous pression à l'aide de soupapes magnétiques constituées par une soupape (44) et une bobine de soupape (4), pour le montage sur un bloc de soupapes (40) comportant les soupapes (44), cet appareil comprenant un boîtier (2,3,42,43), constitué par un cadre (2,42) entourant les bobines de soupapes (4) et un couvercle (3,43) appliqué sur le cadre (2,42) du boîtier et un support de circuit (7,8) disposé à l'intérieur du boîtier (2,3,42,43), caractérisé par le fait que les bobines de soupapes (42) sont insérées élastiquement dans le cadre (2,42) du boîtier et sont reliées électriquement au support de circuit (7,8).

2. Appareil selon la revendication 1, caractérisé en ce que les bobines de soupapes (4) sont fixées dans le cadre (2,42) dans une position prédéterminée, au moyen d'une masse de scellement (6).

3. Appareil selon la revendication 1, caractérisé en ce que le support de circuit (7,8) comporte des contacts à souder (12), qui sont encliquetés dans le support et dans lesquels sont soudées les bornes (11) des bobines de soupapes (4).
